# EUROPÄISCHE PATENTANMELDUNG

(11) **EP 3 696 854 A1**
(43) Veröffentlichungstag der Anmeldung: **19.08.2020**
(21) Anmeldenummer: 19156929.2
(22) Anmeldetag: 13.02.2019
(51) Int. Cl.: H01L 25/07, H01L 23/00

(54) **LEISTUNGSHALBLEITERMODUL UND VERFAHREN ZUR HERSTELLUNG EINES LEISTUNGSHALBLEITERMODULS**

(71) Anmelder: Siemens Aktiengesellschaft, 80333 München (DE)
(72) Erfinder: Wagner, Claus Florian, 90425 Nürnberg (DE); Woiton, Michael, 90425 Nürnberg (DE)

(57) **Zusammenfassung**

Die Erfindung betrifft ein Leistungshalbleitermodul (2) mit zumindest einem Leistungshalbleiterelement (4), das flächig auf einem Substrat (6) aufliegt, zumindest einem metallischen Kontaktierungselement (16) und zumindest einer Stromschiene (20) mit einem Kontaktierungsabschnitt (20a). Um eine lange Lebensdauer und einen geringen Platzbedarf zu erreichen, wird vorgeschlagen, dass das metallische Kontaktierungselement (16) auf einer dem Substrat (6) abgewandten Seite des Leistungshalbleiterelements (4) flächig aufliegt, wobei der Kontaktierungsabschnitt (20a) unmittelbar mit dem metallischen Kontaktierungselement (16) kontaktiert und im Wesentlichen senkrecht zur dem Substrat (6) abgewandten Seite des Leistungshalbleiterelements (4) verlaufend angeordnet ist.

## Beschreibung

Die Erfindung betrifft ein Leistungshalbleitermodul.

Ferner betrifft die Erfindung einen Stromrichter mit zumindest einem derartigen Leistungshalbleitermodul.

Darüber hinaus betrifft die Erfindung ein Verfahren zur Herstellung eines Leistungshalbleitermoduls.

Mit zunehmender Miniaturisierung von Leistungshalbleitermodulen, die einen in einem Gehäuse angeordneten Leistungshalbleiter umfassen, stellen die Baugröße, die Lebensdauer und die Kosten zunehmend eine Herausforderung dar. Die oberseitige Kontaktierung, insbesondere vertikaler, Leistungshalbleiter erfolgt nach dem Stand der Technik vorwiegend über Aluminium Wirebonds. Derartige Bonddrähte sind einer der wichtigsten lebensdauerbegrenzenden Faktoren. Zur Erhöhung der Lebensdauer werden inzwischen auch Kupfer Wirebonds eingesetzt, die jedoch eine entsprechende Metallisierung auf dem Leistungshalbleiter erfordern. Ferner ist eine für den Bondprozess mit Kupfer Wirebonds erforderliche Energie und die daraus resultierende mechanische Belastung des Leistungshalbleiters deutlich höher als bei Aluminium Wirebonds, wodurch die Gefahr einer Beschädigung des Leistungshalbleiters besteht.

Die Patentschrift DE 10 2013 102 829 B4 beschreibt ein hermetisch dichtes Leistungshalbleitermodul mit einem Substrat, einem Gehäuse und Anschlusselementen für Last- und Hilfsanschlüsse, wobei das Substrat eine metallische Grundplatte aufweist, auf deren dem Modulinneren zugewandten Hauptfläche ein Isolierstoffkörper mit Leiterbahnen und mindestens einem hierauf angeordneten Leistungshalbleiterbauelement sowie modulinterne Verbindungseinrichtungen angeordnet sind.

Die Offenlegungsschrift DE 10 2015 120 156 A1 beschreibt eine Vorrichtung mit einem ein elastisches Kissenelement aufweisenden Pressstempel zur materialschlüssigen Drucksinterverbindung eines ersten mit einem zweiten Verbindungspartnern eines Leistungselektronik-Bauteils, wobei das elastische Kissenelement des Pressstempels von einem formstabilen Rahmen umgeben ist, innerhalb welchem das Kissenelement und ein Führungsteil des Pressstempels derart linear beweglich geführt werden, dass sich der formstabile Rahmen auf den ersten Verbindungspartner oder einen Werkstückträger mit darin angeordnetem ersten Verbindungspartner, absenkt und nach Anliegen an diesem der Presstempel samt elastischem Kissenelement auf den zweiten Verbindungspartner abgesenkt wird und das elastische Kissen ein notwendiger Druck ausgeübt wird um den ersten mit dem zweiten Verbindungspartner zu verbinden.

Der Erfindung liegt die Aufgabe zugrunde, ein Leistungshalbleitermodul anzugeben, welches eine lange Lebensdauer und einen geringen Platzbedarf aufweist.

Die Aufgabe wird durch ein Leistungshalbleitermodul mit zumindest einem Leistungshalbleiterelement, das flächig auf einem Substrat aufliegt, zumindest einem metallischen Kontaktierungselement und zumindest einer Stromschiene mit einem Kontaktierungsabschnitt gelöst, wobei das metallische Kontaktierungselement auf einer dem Substrat abgewandten Seite des Leistungshalbleiterelements flächig aufliegt, wobei der Kontaktierungsabschnitt unmittelbar mit dem metallischen Kontaktierungselement kontaktiert und im Wesentlichen senkrecht zur dem Substrat abgewandten Seite des Leistungshalbleiterelements verlaufend angeordnet ist.

Die Aufgabe wird darüber hinaus durch einen Stromrichter mit zumindest einem derartigen Leistungshalbleitermodul gelöst.

Die Aufgabe wird des Weiteren durch ein Verfahren zur Herstellung eines Leistungshalbleitermoduls mit zumindest einem Leistungshalbleiterelement, zumindest einem metallischen Kontaktierungselement und zumindest einer Stromschiene mit einem Kontaktierungsabschnitt gelöst, wobei das Leistungshalbleiterelement flächig auf einem Substrat angeordnet wird, wobei das metallische Kontaktierungselement auf einer dem Substrat abgewandten Seite des Leistungshalbleiterelements flächig aufliegend angeordnet wird, wobei der Kontaktierungsabschnitt unmittelbar mit dem metallischen Kontaktierungselement kontaktiert und im Wesentlichen senkrecht zur dem Substrat abgewandten Seite des Leistungshalbleiterelements verlaufend angeordnet wird.

Die in Bezug auf das Leistungshalbleitermodul nachstehend angeführten Vorteile und bevorzugten Ausgestaltungen lassen sich sinngemäß auf den Stromrichter und das Verfahren übertragen.

Der Erfindung liegt die Überlegung zugrunde, in einem Leistungshalbleitermodul eine oberseitige Kontaktierung von Leistungshalbleitern mittels Stromschienen, welche auch Busbars genannt werden, zu erreichen. Das Leistungshalbleiterelement ist beispielsweise als ein, insbesondere vertikaler, Leistungstransistor, eine Diode oder ein Thyristor ausgeführt. Im Vergleich zu Bonddrähten wird, beispielsweise durch die größere mechanische und thermische Stabilität, eine längere Lebensdauer des Leistungshalbleitermoduls erreicht. Das Leistungshalbleiterelement liegt das flächig auf einem Substrat auf, wobei das Substrat beispielsweise als Dielektrikum mit zumindest einer metallisch strukturierten Oberfläche ausgeführt ist. Um den Leistungshalbleiter vor mechanischer Beschädigung oder Zerstörung zu schützen, wird auf dem Leistungshalbleiter ein metallisches Kontaktierungselement angeordnet, auf welchem ein Kontaktierungsabschnitt der Stromschiene kontaktiert wird. Das metallische Kontaktierungselement ist beispielsweise als Kupferplättchen oder Molybdänplättchen mit einer Dicke von 25 µm bis 250 µm ausgeführt. Da der Kontaktierungsabschnitt der Stromschiene im Wesentlichen senkrecht auf dem metallischen Kontaktierungselement angeordnet ist, werden keine elektrischen Feldlinien im Leistungshalbleiterelement verändert, was sich positiv auf die elektrischen Eigenschaften des Leistungshalbleitermoduls im Betrieb auswirkt. Der Kontaktierungsabschnitt ist unmittelbar mit dem metallischen Kontaktierungselement kontaktiert. Eine unmittelbare Kontaktierung bedeutet, dass der Kontaktierungsabschnitt direkt mit dem metallischen Kontaktierungselement verbunden ist, wobei eine unmittelbare Kontaktierung Verbindungsmittel wie Kleber, Lötzinn, ... einschließt, Verbindungselemente wie zusätzliche Leiter, Bonddrähte, Abstandshalter, ... ausschließt. Da durch die unmittelbare Kontaktierung Verbindungselemente entfallen, welche langfristig, beispielsweise durch zyklisches Stressen, zerstört werden, wird die Lebensdauer des Leistungshalbleitermoduls deutlich vergrößert.

Die Stromschienen sind als AC-Stromschienen zur Übertragung von AC-Leistungssignalen oder als DC-Stromschienen zur Übertragung von DC-Leistungssignalen ausführbar. Da Strompfade von AC-Leistungssignalen sehr nahe aneinander führbar sind, wird ein niederinduktiver Aufbau durch AC-Stromschienen erreicht, was sich positiv auf die elektrischen Eigenschaften des Leistungshalbleitermoduls im Betrieb auswirkt. Ferner wird durch DC-Stromschienen und einem damit verbundenen Wegfall von DC-Potentialen auf dem Substrat eine Platzeinsparung erreicht.

In einer bevorzugten Ausgestaltung ist eine Kontaktfläche zwischen dem Kontaktierungselement und dem Leistungshalbleiterelement größer als ein Leiterquerschnitt der Stromschiene im Bereich des Kontaktierungsabschnitts. Beispielsweise ist die Kontaktfläche zwischen dem Kontaktierungselement und dem Leistungshalbleiterelement mindestens fünf Mal größer als der Leiterquerschnitt der Stromschiene im Bereich des Kontaktierungsabschnitts. Durch einen derartigen Unterschied in der Fläche wird eine Positionierung der Stromschienen erleichtert und eine Druckverteilung auf dem Leistungshalbleiterelement wird verbessert.

Besonders vorteilhaft ist das metallische Kontaktierungselement stoffschlüssig mit dem Leistungshalbleiterelement verbunden. Eine derartige stoffschlüssige Verbindung wird beispielsweise über Löten oder Sintern hergestellt. Durch die stoffschlüssige Verbindung wird eine optimale elektrische und thermische Anbindung des Kontaktierungselements an das Leistungshalbleiterelement erreicht.

Bei einer weiteren vorteilhaften Ausführungsform ist der Kontaktierungsabschnitt mit dem metallischen Kontaktierungselement kraftschlüssig verbunden. Beispielsweise wird der Kontaktierungsabschnitt auf das metallische Kontaktierungselement gedrückt und so eine thermisch und elektrisch leitfähige Verbindung hergestellt. Eine derartige Verbindung ist lösbar und einfach zu fertigen.

Besonders vorteilhaft wird über den Kontaktierungsabschnitt eine senkrecht auf das Leistungshalbleiterelement wirkende Kraft übertragen. Durch eine senkrecht auf das Leistungshalbleiterelement wirkende Kraft wird das Leistungshalbleiterelement besonders zuverlässig lösbar fixiert.

Bei einer weiteren vorteilhaften Ausführungsform umfasst das Leistungshalbleitermodul ein Druckstück, welches derartig an der Stromschiene kontaktiert ist, dass die Kraft vom Druckstück über die Stromschiene auf das Leistungshalbleiterelement übertragen wird. Über ein Druckstück wird, insbesondere bei mehreren Leistungshalbleiterelementen, eine optimale Druckverteilung gewährleistet.

Besonders vorteilhaft wird durch das Druckstück zumindest ein Teil eines Gehäuses des Leistungshalbleitermoduls gebildet, was zu einer erheblichen Verkleinerung des Leistungshalbleitermoduls führt.

In einer bevorzugten Ausgestaltung steht das Leistungshalbleiterelement über das Substrat mit einem Kühlelement in einer elektrisch isolierenden und thermisch leitfähigen Verbindung und das Substrat wird durch die senkrecht auf das Leistungshalbleiterelement wirkende Kraft von der Stromschiene auf das Kühlelement gepresst. Das Kühlelement weist beispielsweise einen, insbesondere metallischen, Kühlkörper auf. Durch den Druck wird das Substrat an den Stellen auf das Kühlelement gepresst an denen Wärme durch den Betrieb der Leistungshalbleiterelemente entsteht und abgeführt werden muss, wodurch die Kühleffizienz verbessert wird.

Besonders vorteilhaft ist der Kontaktierungsabschnitt der Stromschiene im Wesentlichen starr ausgeführt. "Im Wesentlichen starr" in Zusammenhang mit der Erfindung bedeutet, dass die Stromschiene steif und durch übliche Belastungen im Wesentlichen weder elastisch noch plastisch verformbar ist. Bei den "üblichen Belastungen" handelt es sich insbesondere um solche Belastungen, die während der Verwendung einer erfindungsgemäßen Stromschiene im Einbauzustand auftreten. Durch eine starre Ausgestaltung der Stromschiene ist die auf das Leistungshalbleiterelement wirkende Kraft leicht und zuverlässig dosierbar.

Bei einer weiteren vorteilhaften Ausführungsform weist die Stromschiene einen rechteckigen oder quadratischen Leiterquerschnitt auf. Insbesondere bei der im Leistungshalbleitermodul verwendeten Größenordnung ist die Stromschiene mit einem derartig ausgeführten Leiterquerschnitt besonderes leicht herstellbar.

In einer bevorzugten Ausgestaltung ist das metallische Kontaktierungselement derartig auf dem Leistungshalbleiterelement angeordnet, dass zumindest eine Randstruktur des Leistungshalbleiters ausgespart ist. Beispielsweise weist die Randstruktur eine Breite von mindestens 400 µm auf. Durch eine derartige Aussparung am Rand des Leistungshalbleiterelements werden keine elektrischen Feldlinien im Leistungshalbleiterelement verändert, was sich positiv auf die elektrischen Eigenschaften des Leistungshalbleitermoduls im Betrieb auswirkt.

Bei einer weiteren vorteilhaften Ausführungsform weist die Stromschiene im Bereich der Kontaktierung mit dem metallischen Kontaktierungselement eine Profilierung auf. Die Profilierung ist beispielsweise sägezahnförmig, wellenförmig, pyramidenförmig oder würfelförmig. Durch die Profilierung wir die lösbare mechanische Verbindung zwischen der Stromschiene und dem Kontaktierungselement stabilisiert.

Besonders vorteilhaft weist das metallische Kontaktierungselement eine zur Profilierung der Stromschiene korrespondierende Profilierung auf. Durch eine korrespondierende Profilierung wird zusätzlich zum Kraftschluss ein Formschluss erreicht, welcher die lösbare mechanische Verbindung zwischen der Stromschiene und dem Kontaktierungselement zusätzlich stabilisiert.

In einer weiteren vorteilhaften Ausgestaltung weisen mindestens zwei Stromschienen jeweils einen Überbrückungsabschnitt auf, in dem die mindestens zwei Stromschienen parallel zueinander verlaufend angeordnet sind. Der parallele Verlauf der Stromschienen verbessert die Übersichtlichkeit und erleichtert eine Fehlerdiagnose.

Bei einer weiteren vorteilhaften Ausführungsform sind die mindestens zwei Stromschienen zumindest im Bereich der Überbrückungsabschnitte durch einen Isolationswerkstoff voneinander isoliert. Der Isolationswerkstoff ist beispielsweise ein Polymer oder ein andere isolierender Kunststoff, welcher insbesondere als Polymerfolie aufgeführt ist. Alternativ wird eine Isolation über Pulverbeschichtung hergestellt. Ein Isolationswerkstoff zwischen den Stromschienen führt zu einer Verbesserung der mechanischen Stabilität.

Im Folgenden wird die Erfindung anhand der in den Figuren dargestellten Ausführungsbeispiele näher beschrieben und erläutert.

Es zeigen:
- FIG 1: eine Schnittdarstellung eines Leistungshalbleitermoduls,
- FIG 2: eine vergrößerte Schnittdarstellung eines Leistungshalbleitermoduls im Bereich eines Leistungshalbleiters und
- FIG 3: eine Draufsicht eines Leistungstransistors.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

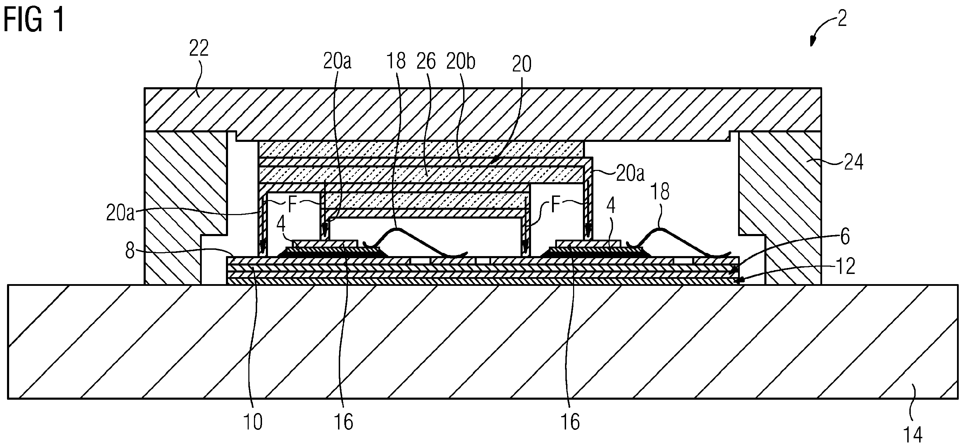

FIG 1 zeigt eine Schnittdarstellung eines Leistungshalbleitermoduls 2, welches Leistungshalbleiterelemente 4 umfasst, die flächig auf einem isolierenden Substrat 6 aufliegen. Insbesondere sind die Leistungshalbleiterelemente 4 jeweils als ein Leistungstransistor oder als ein Thyristor ausgeführt, wobei ein Leistungstransistor beispielsweise ein IGBT (Insulate Gate Bipolar Transistor), ein SiC MOSFET (Siliciumcarbid Metal Oxide Semiconductor Field-Effect Transistor) oder ein GaN (Galliumnitrid) Transistor ist.

Das isolierende Substrat 6 umfasst ein beidseitig mit Leiterbahnen 8 strukturiertes, beispielsweise keramisches, Dielektrikum 10. Die Leistungshalbleiterelemente 4 sind jeweils mit zumindest einer Leiterbahn 8 des Substrats 6, insbesondere stoffschlüssig, verbunden. Beispielsweise werden die Leistungshalbleiterelemente 4 auf das das Substrat 6 gelötet oder gesintert. Insbesondere ist das isolierende Substrat 6 als DCB (engl. Direct Copper Bonded) Substrat ausgeführt, welches eine enge elektrisch und thermische Verbindung des Leistungshalbleiters 4 mit dem Substrat 6 ermöglicht. Das Substrat 6 ist über eine thermische Schnittstelle 12 mit einem Kühlelement 14, beispielsweise einem, insbesondere metallischen, Kühlkörper, verbunden. Die thermische Schnittstelle 12 umfasst beispielsweise Wärmeleitpaste. Das Leistungshalbleiterelement 4 steht über das Substrat 6 mit dem Kühlkörper in einer elektrisch isolierenden und thermisch leitfähigen Verbindung.

Exemplarisch sind die Leistungshalbleiterelemente 4 in FIG 1 als IGBTs ausgeführt, wobei jeweils der Kollektoranschluss des jeweiligen IGBTs mit einer strukturierten Leiterbahn 8 des Substrats 6 verbunden ist. Entsprechend befinden sich der Emitteranschluss und der Gateanschluss des jeweiligen IGBTs auf der gegenüberliegenden dem Substrat 6 abgewandten Seite des Leistungshalbleiterelements 4. Auf der dem Substrat 6 abgewandten Seite des Leistungshalbleiterelements 4 liegt ein metallisches Kontaktierungselement 16 flächig auf, wobei das metallisches Kontaktierungselement 16 beispielsweise als Kupferplättchen oder Molybdänplättchen mit einer Dicke von 25 µm bis 250 µm ausgeführt ist. Insbesondere ist das metallisches Kontaktierungselement 16 mit dem Emitteranschluss des Leistungshalbleiterelements 4 stoffschlüssig verbunden. Eine Kontaktierung mit dem Drain- und Sourceanschluss eines SiC MOSFETS erfolgt analog. Die stoffschlüssige Verbindung wird beispielsweise über Löten oder Sintern hergestellt. Das metallische Kontaktierungselement 16 ist derartig mit dem Leistungshalbleiterelement 4 verbunden, dass zumindest eine Randstruktur, insbesondere mit einer Breite von mindestens 400 pm, des Leistungshalbleiterelements 4 ausgespart ist. Ferner wird der Gateanschluss durch das Kontaktierungselement 16 ausgespart. Der Gateanschluss des Leistungshalbleiterelements 4 wird exemplarisch über einen Bonddraht 18 mit einer strukturierten Leiterbahn 8 des Substrats 6 verbunden.

Auf einer dem Leistungshalbleiter 4 abgewandten Seite des Kontaktierungselements 16 ist eine Stromschiene 20 kontaktiert. Die Stromschiene 20 umfasst einen im Wesentlichen senkrecht zur dem Leistungshalbleiter 4 abgewandten Seite des Kontaktierungselements 16 verlaufenden Kontaktierungsabschnitt 20a und einen parallel zur dem Leistungshalbleiter 4 abgewandten Seite des Kontaktierungselements 16 verlaufenden Überbrückungsabschnitt 20b. Demnach verlaufen der Kontaktierungsabschnitt 20a vertikal und der Überbrückungsabschnitt 20b horizontal. Die Stromschiene 20 weist einen metallischen Leiter auf, welcher beispielsweise aus Kupfer hergestellt ist und einen rechteckigen oder quadratischen Leiterquerschnitt aufweist. Eine Kontaktfläche zwischen dem metallischen Kontaktierungselement 16 und dem Leistungshalbleiterelement 4 ist größer als ein Leiterquerschnitt der Stromschiene 20 im Bereich des Kontaktierungsabschnitts 20a.

Eine Stromschiene 20, die zwei Leistungshalbleiter 4 miteinander verbindet, weist zwei im Wesentlichen parallel zueinander verlaufende vertikale Kontaktierungsabschnitte 20a auf, die über einen horizontalen Überbrückungsabschnitt 20b miteinander verbunden sind. Die Kontaktierungsabschnitte 20a sind unmittelbar mit dem metallischen Kontaktierungselement 16 elektrisch und thermisch leitend kontaktiert. Eine unmittelbare Kontaktierung bedeutet, dass die Kontaktierungsabschnitte 20a direkt mit den jeweiligen metallischen Kontaktierungselementen 16 verbunden sind, wobei eine unmittelbare Kontaktierung Verbindungsmittel wie Kleber, Lötzinn, ... einschließt, Verbindungselemente wie zusätzliche Leiter, Bonddrähte, Abstandshalter, ... ausschließt. Die Stromschienen 20 sind als AC-Stromschienen zur Übertragung von AC-Leistungssignalen oder als DC-Stromschienen zur Übertragung von DC-Leistungssignalen ausgeführt.

Von einem Druckstück 22 wird eine vertikale Kraft F über den Kontaktierungsabschnitt 20a der Stromschiene 20 und das Kontaktierungselement 16 auf das Leistungshalbleiterelement 4 übertragen, wobei der Kontaktierungsabschnitt 20a der Stromschiene 20 im Wesentlichen starr ausgeführt ist. Auf diese Weise wird eine kraftschlüssige Verbindung zwischen dem Kontaktierungsabschnitt 20a der Stromschiene 20 und dem metallischen Kontaktierungselement 16 erzeugt. Ferner wird über die vertikale Kraft F das Substrat 6 auf das Kühlelement 14 gepresst. Durch die Stromschiene 20 wird das Substrat 6 den Stellen auf das Kühlelement 14 gepresst an denen Wärme durch den Betrieb der Leistungshalbleiterelemente 4 entsteht und abgeführt werden muss. Die Dicke der Wärmeleitpaste unterhalb des Substrats 6 wird durch den Anpressdruck lokal minimiert, was zu einer Verringerung des thermischen Widerstands führt. Das Druckstück 22 ist Teil eines Gehäuses 24 des Leistungshalbleitermoduls 2, was zu einer Verkleinerung des Leistungshalbleitermoduls 2 führt.

Zwischen den parallel zueinander verlaufenden Überbrückungsabschnitten 20b der Stromschienen 20 ist ein Isolationswerkstoff 26 angeordnet, welcher die Stromschienen 20 voneinander beabstandet und isoliert. Der Isolationswerkstoff ist beispielsweise ein Polymer oder ein andere isolierender Kunststoff, welcher insbesondere als Polymerfolie aufgeführt ist. Alternativ wird eine Isolation über Pulverbeschichtung hergestellt.

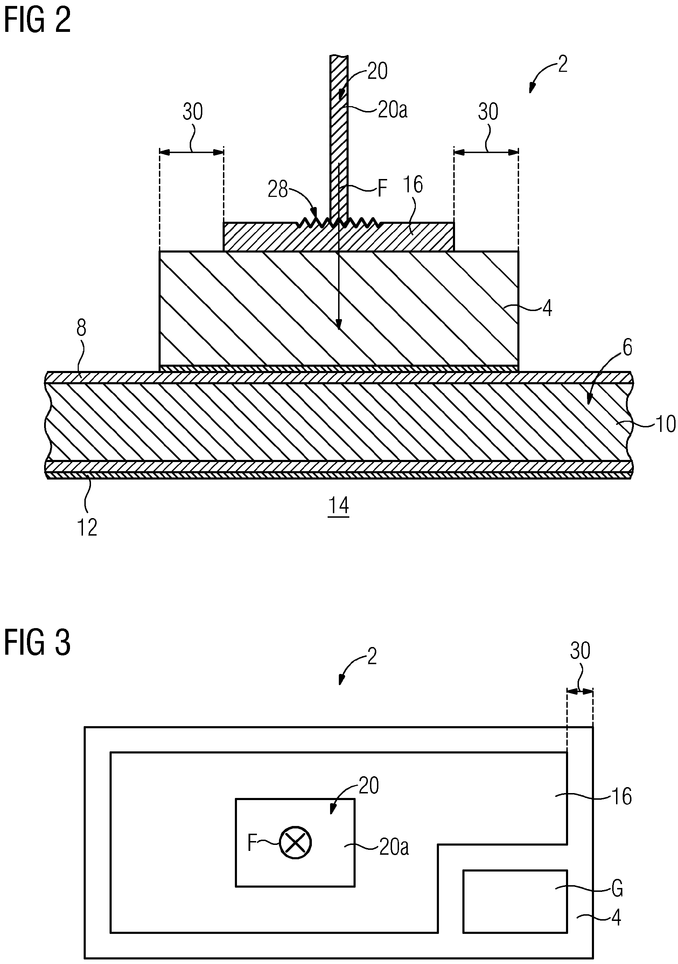

FIG 2 zeigt eine vergrößerte Schnittdarstellung eines Leistungshalbleitermoduls 2 im Bereich eines Leistungshalbleiters 4, wobei der Kontaktierungsabschnitt 20a der Stromschiene 20 im Bereich der Kontaktierung mit dem metallischen Kontaktierungselement 16 eine Profilierung 28 aufweist. Optional weist das metallische Kontaktierungselement 16 eine zur Profilierung 28 des Kontaktierungsabschnitts 20a der Stromschiene 20 korrespondierende Profilierung 28 auf, wobei sich bei der Kontaktierung der Stromschiene 20 die Profilierung 28 des Kontaktierungsabschnitts 20a mit der Profilierung 28 des Kontaktierungselements 16 verzahnt. Durch eine derartige Verzahnung wird neben der kraftschlüssigen Verbindung zwischen dem Kontaktierungsabschnitt 20a der Stromschiene 20 und dem Kontaktierungselement 16 ein zusätzlicher Formschluss erreicht. Das metallische Kontaktierungselement 16 ist derartig auf dem Leistungshalbleiterelement 4 angeordnet, dass zumindest eine Randstruktur 30 des Leistungshalbleiters 4 ausgespart ist. Die weitere Ausgestaltung des Leistungshalbleitermoduls 2 in FIG 2 entspricht der in FIG 1.

FIG 3 zeigt eine Draufsicht eines Leistungstransistors, welcher beispielsweise als IGBT ausgeführt ist. Alternativ ist der Leistungstransistor als SiC MOSFET oder als ein anderer vertikaler Leistungstransistor ausgeführt. Das metallische Kontaktierungselement 16 ist derartig ausgestaltet und auf dem als Leistungstransistor ausgeführten Leistungshalbleiter 4 angeordnet, dass eine möglichst große Kontaktfläche erreicht wird und sowohl eine Randstruktur 30 als auch ein Gateanschluss G des Leistungstransistors ausgespart sind. Der Gateanschluss G wird beispielsweise über einen Bonddraht, welcher in FIG 3 aus Gründen der Übersichtlichkeit nicht dargestellt ist, mit einer Leiterbahn9 des Substrats 6 verbunden. Die weitere Ausgestaltung des Leistungshalbleitermoduls 2 in FIG 3 entspricht der in FIG 2.

Zusammenfassend betrifft die Erfindung ein Leistungshalbleitermodul 2 mit zumindest einem Leistungshalbleiterelement 4, das flächig auf einem Substrat 6 aufliegt, zumindest einem metallischen Kontaktierungselement 16 und zumindest einer Stromschiene 20 mit einem Kontaktierungsabschnitt 20a. Um eine lange Lebensdauer und einen geringen Platzbedarf zu erreichen, wird vorgeschlagen, dass das metallische Kontaktierungselement 16 auf einer dem Substrat 6 abgewandten Seite des Leistungshalbleiterelements 4 flächig aufliegt, wobei der Kontaktierungsabschnitt 20a unmittelbar mit dem metallischen Kontaktierungselement 16 kontaktiert und im Wesentlichen senkrecht zur dem Substrat 6 abgewandten Seite des Leistungshalbleiterelements 4 verlaufend angeordnet ist.

## Patentansprüche

1. Leistungshalbleitermodul (2) mit
zumindest einem Leistungshalbleiterelement (4), das flächig auf einem Substrat (6) aufliegt,
zumindest einem metallischen Kontaktierungselement (16) und zumindest einer Stromschiene (20) mit einem Kontaktierungsabschnitt (20a),
wobei das metallische Kontaktierungselement (16) auf einer dem Substrat (6) abgewandten Seite des Leistungshalbleiterelements (4) flächig aufliegt,
wobei der Kontaktierungsabschnitt (20a) unmittelbar mit dem metallischen Kontaktierungselement (16) kontaktiert und
im Wesentlichen senkrecht zur dem Substrat (6) abgewandten Seite des Leistungshalbleiterelements (4) verlaufend angeordnet ist.

2. Leistungshalbleitermodul (2) nach Anspruch 1,
wobei eine Kontaktfläche zwischen dem Kontaktierungselement (16) und dem Leistungshalbleiterelement (4) größer ist als ein Leiterquerschnitt der Stromschiene (20) im Bereich des Kontaktierungsabschnitts (20a).

3. Leistungshalbleitermodul (2) nach einem der Ansprüche 1 oder 2,
wobei das metallische Kontaktierungselement (16) stoffschlüssig mit dem Leistungshalbleiterelement (4) verbunden ist.

4. Leistungshalbleitermodul (2) nach einem der vorherigen Ansprüche,
wobei der Kontaktierungsabschnitt (20a) mit dem metallischen Kontaktierungselement (16) kraftschlüssig verbunden ist.

5. Leistungshalbleitermodul (2) nach einem der vorherigen Ansprüche,
wobei über den Kontaktierungsabschnitt (20a) eine senkrecht auf das Leistungshalbleiterelement (4) wirkende Kraft (F) übertragen wird.

6. Leistungshalbleitermodul (2) nach Anspruch 5,
umfassend ein Druckstück (22), welches derartig an der Stromschiene (20) kontaktiert ist,
dass die Kraft (F) vom Druckstück (22) über die Stromschiene (20) auf das Leistungshalbleiterelement (4) übertragen wird.

7. Leistungshalbleitermodul (2) nach Anspruch 6,
wobei durch das Druckstück (22) zumindest ein Teil eines Gehäuses (24) des Leistungshalbleitermoduls (2) gebildet ist.

8. Leistungshalbleitermodul (2) nach einem der Ansprüche 4 bis 7,
wobei das Leistungshalbleiterelement (4) über das Substrat (6) mit einem Kühlelement (14) in einer elektrisch isolierenden und thermisch leitfähigen Verbindung steht und
wobei das Substrat (6) durch die senkrecht auf das Leistungshalbleiterelement (4) wirkende Kraft (F) von der Stromschiene (20) auf das Kühlelement (14) gepresst wird.

9. Leistungshalbleitermodul (2) nach einem der vorherigen Ansprüche,
wobei der Kontaktierungsabschnitt (20a) der Stromschiene (20) im Wesentlichen starr ausgeführt ist.

10. Leistungshalbleitermodul (2) nach einem der vorherigen Ansprüche,
wobei die Stromschiene (20) einen rechteckigen oder quadratischen Leiterquerschnitt aufweist.

11. Leistungshalbleitermodul (2) nach einem der vorherigen Ansprüche,
wobei das metallische Kontaktierungselement (16) derartig auf dem Leistungshalbleiterelement (4) angeordnet ist, dass zumindest eine Randstruktur (30) des Leistungshalbleiters (4) ausgespart ist.

12. Leistungshalbleitermodul (2) nach einem der vorherigen Ansprüche,
wobei die Stromschiene (20) im Bereich der Kontaktierung mit dem metallischen Kontaktierungselement (16) eine Profilierung (28) aufweist.

13. Leistungshalbleitermodul (2) nach Anspruch 12,
wobei das metallische Kontaktierungselement (16) eine zur Profilierung (28) der Stromschiene (20) korrespondierende Profilierung (28) aufweist.

14. Leistungshalbleitermodul (2) nach einem der vorherigen Ansprüche,
wobei mindestens zwei Stromschienen (20) jeweils einen Überbrückungsabschnitt (20b) aufweisen, in dem die mindestens zwei Stromschienen (20) parallel zueinander verlaufend angeordnet sind.

15. Leistungshalbleitermodul (2) nach Anspruch 14,
wobei die mindestens zwei Stromschienen (20) zumindest im Bereich der Überbrückungsabschnitte (20b) durch einen Isolationswerkstoff (26) voneinander isoliert sind.

16. Stromrichter mit zumindest einem Leistungshalbleitermodul (2) nach einem der vorherigen Ansprüche.

17. Verfahren zur Herstellung eines Leistungshalbleitermoduls (2) mit zumindest einem Leistungshalbleiterelement (4), zumindest einem metallischen Kontaktierungselement (16) und zumindest einer Stromschiene (20) mit einem Kontaktierungsabschnitt (20a),
wobei das Leistungshalbleiterelement (4) flächig auf einem Substrat (6) angeordnet wird,
wobei das metallische Kontaktierungselement (16) auf einer dem Substrat (6) abgewandten Seite des Leistungshalbleiterelements (4) flächig aufliegend angeordnet wird,
wobei der Kontaktierungsabschnitt (20a) unmittelbar mit dem metallischen Kontaktierungselement (16) kontaktiert und
im Wesentlichen senkrecht zur dem Substrat (6) abgewandten Seite des Leistungshalbleiterelements (4) verlaufend angeordnet wird.

18. Verfahren nach Anspruch 17,
wobei das metallische Kontaktierungselement (16) stoffschlüssig mit dem Leistungshalbleiterelement (4) verbunden ist.

19. Verfahren nach einem der Ansprüche 17 oder 18,
wobei der Kontaktierungsabschnitt (20a) mit dem metallischen Kontaktierungselement (16) kraftschlüssig verbunden wird.

20. Verfahren nach einem der Ansprüche 17 bis 19,
wobei das Leistungshalbleitermodul (2) ein Druckstück (22) umfasst, welches derartig an der Stromschiene (20) kontaktiert wird, dass eine senkrecht auf das Leistungshalbleiterelement (4) wirkende Kraft (F) vom Druckstück (22) über die Stromschiene (20) auf das Leistungshalbleiterelement (4) übertragen wird.

21. Verfahren nach einem der Ansprüche 17 bis 20,
wobei durch das Druckstück (22) zumindest ein Teil eines Gehäuses (24) des Leistungshalbleitermoduls (2) gebildet wird.

22. Verfahren nach einem der Ansprüche 17 bis 21,
wobei das metallische Kontaktierungselement (16) derartig auf dem Leistungshalbleiterelement (4) angeordnet wird,
dass zumindest eine Randstruktur (30) des Leistungshalbleiters (4) ausgespart wird.

23. Verfahren nach einem der Ansprüche 17 bis 22,
wobei mindestens zwei Stromschienen (20) jeweils einen Überbrückungsabschnitt (20b) aufweisen, in dem die mindestens zwei Stromschienen (20) parallel zueinander verlaufend angeordnet werden.

24. Verfahren nach Anspruch 23,
wobei die mindestens zwei Stromschienen (20) zumindest im Bereich der Überbrückungsabschnitte (20b) durch einen Isolationswerkstoff (26) voneinander isoliert werden.
